# FASCICULE DE BREVET EUROPEEN

(11) **EP 2 875 172 B1**
(45) Date de publication et mention de la délivrance du brevet: **06.11.2019**
(21) Numéro de dépôt: 13747478.9
(22) Date de dépôt: 22.07.2013
(51) Int. Cl.: C30B 29/18, C30B 5/00, C30B 1/02, C30B 1/00

(54) **PROCÉDÉ DE PRÉPARATION D'UNE COUCHE DE QUARTZ-ALPHA EPITAXIÉE SUR SUPPORT SOLIDE, MATÉRIAU OBTENU ET APPLICATIONS**
VERFAHREN ZUR HERSTELLUNG EINER EPITAKTISCHEN ALPHA-QUARZSCHICHT AUF EINEM FESTEN TRÄGER, IN DIESEM VERFAHREN HERGESTELLTES MATERIAL UND VERWENDUNGEN DAVON
PROCESS FOR PREPARING AN EPITAXIAL ALPHA-QUARTZ LAYER ON A SOLID SUBSTRATE, MATERIAL OBTAINED AND USES

(30) Priorité: 23.07.2012 FR 1257101
(43) Date de publication de la demande: 27.05.2015
(73) Titulaire: Sorbonne Université, 75006 Paris (FR); Centre National de la Recherche Scientifique, 75016 Paris (FR); Consejo Superior De Investigaciones Científicas (CSIC), 28006 Madrid (ES)
(72) Inventeur: BOISSIERE, Cédric, F-91140 Villebon Sur Yvette (FR); CARRETERO-GENEVRIER, Adrien, F-75010 Paris (FR); GICH, Marti, E-08206 Sabadell Barcelona (ES); GROSSO, David, F-91630 Cheptainville (FR); SANCHEZ, Clément, F-91440 Bures-Sur-Yvette (FR)
(74) Mandataire: Lavoix
(86) Numéro de dépôt international: PCT/FR2013/051766
(87) Numéro de publication internationale: WO 2014/016506

(56) Documents cités:
- ES-A1- 2 288 129
- JP-A- 2008 273 824
- US-A- 6 028 020
- US-A1- 2002 060 319

## Description

La présente invention est relative à un procédé de préparation de couches de quartz-α épitaxiées sur substrat solide, au matériau obtenu selon ce procédé, et à ses diverses applications, notamment dans le domaine de l'électronique.

Le quartz est le minéral le plus abondant de l'écorce terrestre après le feldspath. Il est massivement extrait afin d'être utilisé dans l'industrie sous forme de sables et de graviers pour diverses applications telles que la fabrication du verre, la fonderie ou la fracturation hydraulique. Cependant, il existe une demande croissante pour du quartz monocristallin (quartz-α) se présentant sous la forme de couche mince. Par exemple, du fait de ses propriétés piézoélectriques, le quartz-α est un matériau de choix pour la fabrication des oscillateurs présents dans les dispositifs électroniques. Cette propriété du quartz-α en fait également un excellent transducteur pour les capteurs de masse, largement utilisés en chimie et en biologie. De plus, le quartz-α présente d'autres propriétés intéressantes telles qu'une activité optique, une biréfringence, une transparence à la lumière depuis l'UV dans le vide jusqu'au proche infrarouge, et dans les régions TeraHertz (THz) du spectre, une grande dureté et une durabilité chimique remarquable (P. Shumyatsky, R. R. Alfano, J. Biomed. Opt., 2011, 16, 033001 ; Doling G., Journal of Physics and Chemistry of Solids, 1979, 40, 121).

Différentes méthodes de préparation de quartz-α ont déjà été proposées comme la cristallisation de la silice amorphe ou des méthodes chimiques. Parmi celles-ci, la seule méthode conventionnelle de préparation de quartz-α est la synthèse hydrothermale comprenant la croissance d'un monocristal sur un germe cristallin dans une solution alcaline de dioxyde de silicium à haute pression et haute température, telle que décrit notamment par R. A. Laudise (J. Chem. Eng. News, 1987, 65(39), 30-43). Il s'agit d'un procédé gourmand en énergie et long puisque la synthèse doit être poursuivie pendant environ un mois afin d'obtenir de gros cristaux par ailleurs ces procédés conduisent pour la plupart à une conversion incomplète en quartz-α avec la présence d'autres phases SiO₂ cristallines alors qu'aucun ne permet l'obtention de couches minces. En conséquence, les cristaux préparés par synthèse hydrothermale doivent ensuite être découpés et polis. Ces étapes de finition entrainent des pertes de matière faisant chuter le rendement du procédé en dessous de 10 % et imposent une limite à l'épaisseur minimale des couches de quartz qui se situe autour des 50 microns.

Les problématiques décrites ci-dessus ont motivé des recherches ayant pour but la préparation de couches minces de quartz-α. D'une part, des travaux on porté sur l'amorphisation par bombardement et implantation d'ions dans des cristaux de quartz et sa recristallisation ultérieure utilisant des ions ³⁰Si⁺ et ¹⁶O⁺, (G. Devaud et al. J. Non-Cryst. Solids, 1994, 134, 129-132), des alcalins comme Cs⁺ (F. Roccaforte et al. Appl. Phys. Lett., 1999, 75, 2903-2905), ou bien encore Na ou Rb (J. Keinonen et al. Appl. Phys. Lett., 2006, 88, 261102). D'autre part, il a déjà été proposé, notamment dans le brevet US 7,186,295, la préparation de couches épitaxiées de quartz sur du saphir (0001) par dépôt chimique en phase vapeur à pression atmosphérique catalysé par la présence de HCl gazeux à partir de TEOS.

La préparation de couches minces de quartz a également été étudiée sur des substrats métalliques comme Mo(112) (T. Schroeder et al., Surf. Rev. Lett., 2000, 7, 7), Ni(lll) (M. Kundu et Y. Murata, Appl. Phys. Lett., 2002, 80, 1921-1923), Pd(100) (Z. Zhang et al., Thin Solid Films, 2008, 516, 3741) ou Ru(0001) (D. Löffer et al., Phys. Rev. Lett., 2010, 105, 146104). Dans ces exemples, l'épaisseur des couches ne dépasse cependant pas 5 nm et la technique utilisée, dépôt physique sous ultra vide n'est pas industrialisable à bas coût.

Enfin, il a été proposé, notamment selon la méthode décrite dans le brevet US 6,028,020, la préparation de couches minces de quartz cristallin d'épaisseur variant de 5 nm à 50 µm par voie sol-gel. Ce procédé consiste dans une première étape à former sur un substrat une couche d'un film cristallin de dioxyde de germanium, puis à former une monocouche de quartz cristallin sur la couche de dioxyde de germanium précédemment déposée sur le substrat, et enfin à séparer la couche de quartz cristallin du substrat en dissolvant la couche de dioxyde de germanium. Cette méthode nécessite par conséquent la préparation du substrat par une couche de germanium puis l'élimination de cette couche de préparation pour récupérer la couche de quartz cristallin.

Il n'existe donc à ce jour aucune méthode permettant d'accéder simplement, et sans utilisation d'un matériel particulier ou de conditions extrêmes de température ou de pression, à du quartz-α sous la forme de couche mince et dont l'épaisseur peut varier de 5 nm à 50 µm, et ce avec un rendement élevé.

Les inventeurs se sont donc donné pour but de mettre à disposition une telle méthode.

La présente invention a pour objet un procédé de préparation d'une couche de quartz-α épitaxiée sur support solide, comprenant les étapes suivantes :
i) une étape de préparation d'une composition renfermant, dans un solvant, au moins un précurseur de silice et/ou de la silice colloïdale ;
ii) une étape de dépôt d'une couche de la composition obtenue ci-dessus à l'étape i) sur au moins une partie de la surface d'un substrat et la formation d'une couche de matrice de silice amorphe ;
iii) une étape de traitement thermique de la couche de matrice de silice amorphe obtenue à l'étape ii) pour obtenir une couche de quartz-α épitaxiée,
   ledit procédé étant caractérisé en ce que :
   - le substrat est un substrat autosupporté choisi parmi le silicium cristallin mono-orienté, le dioxyde de germanium (GeO₂), le corindon (α-Al₂O₃), l'oxyde de magnésium (MgO), le titanate de strontium (SrTiO₃), le niobiate de lithium (LiNbO₃), le tantalate de lithium (LiTaO₃), l'oxyde de cérium (CeO₂), les oxydes mixtes de gadolinium et de cérium de Ce₍₁₋ₓ₎GdₓO₂ dans lesquels x est tel que 0<x<1, l'aluminate de lanthane (LaAlO₃), le nitrure de gallium (GaN), le dioxyde de zirconium dopé à l'yttrium (ZrO₂:Y) et l'orthophosphate de gallium (GaPO₄), et en ce que :
   - l'étape de traitement thermique de la couche de silice amorphe est réalisée à une température supérieure ou égale à 800°C, en présence d'au moins un catalyseur à base d'un des éléments suivants au degré d'oxydation (+2) : strontium, baryum, calcium, magnésium, béryllium, ou d'un des éléments suivants au degré d'oxydation (+1) : césium, rubidium, lithium, sodium ou potassium, ou capable de générer un des éléments suivants au degré d'oxydation (+2) : strontium, baryum, calcium, magnésium, béryllium, ou un des éléments suivants au degré d'oxydation (+1) : césium, rubidium, sodium, du potassium ou lithium, ledit catalyseur étant présent au sein de ladite matrice de silice amorphe.

Un tel procédé est simple, peu couteux et rapide à mettre en œuvre. Il permet d'obtenir des couches minces de quartz-α épitaxiées avec un rendement élevé et un parfait contrôle de l'épaisseur et de la nanostructure (présence d'une porosité homogène contrôlable), d'épaisseur supérieure 5 nm et allant au moins jusqu'à 50 µm, préférentiellement jusqu'à 10 µm et très préférentiellement jusqu'à 5 µm. Le procédé est également très flexible d'un point de vue chimique dans la mesure ou la couche de quartz-α peut être modifiée en introduisant, dans la composition des tensioactifs ou des polymères blocs pour générer de la porosité ou d'autres éléments tels que des ions ou des nano-objets pré-synthétisés afin d'augmenter les fonctionnalités du matériau obtenu. Enfin, un avantage supplémentaire du procédé conforme à l'invention est l'utilisation du dépôt par voie liquide, ce qui le rend compatible avec des techniques de micro et nanofabrication comme la lithographie par nano impression et le micromoulage capillaire.

Dans la description qui va suivre, l'expression « catalyseur » est utilisée indifféremment pour désigner les catalyseurs à base des éléments mentionnés au degré d'oxydation (+2) ou (+1) ainsi que les catalyseurs capables de générer lesdits éléments au degré d'oxydation (+2) ou (+1).

Selon l'invention, l'étape de traitement thermique est de préférence réalisée en présence d'oxygène (à l'air), et comme indiqué précédemment d'un catalyseur tel que défini ci-dessus qui a pour effet de catalyser la cristallisation de la matrice de silice amorphe sous forme de quart-α. En effet, la présence de la surface de silicium monocristallin induit la nucléation croissance des cristaux de quartz-α dans une direction unique correspondant à une relation d'épitaxie. En d'autres termes, le substrat de silicium joue le rôle d'une surface de nucléation sur laquelle la croissance du quartz est favorisée selon une orientation pour laquelle la symétrie est similaire et les distances séparant les rangées d'atomes sont également similaires. Le résultat est l'obtention d'une couche de quartz polycristallin mono orienté, d'épaisseur et de nanostructure contrôlable. L'étape de traitement thermique est par ailleurs de préférence réalisée à pression atmosphérique.

Selon une première forme de réalisation, le catalyseur est présent dans la composition préparée à l'étape i) et se retrouve piégé dans la matrice de silice amorphe lors de sa formation. Dans ce cas, ledit catalyseur représente de préférence de 0,2 à 30 % molaire par rapport à la quantité de précurseur de silice et/ou de silice colloïdale, et encore plus préférentiellement de 5 à 15% molaire.

Selon une seconde forme de réalisation du procédé de l'invention, le catalyseur est introduit dans la matrice de silice amorphe à la fin de l'étape ii) et avant la réalisation de l'étape iii) de traitement thermique. Dans ce cas, la couche de matrice de silice amorphe est imprégnée par une solution d'imprégnation contenant au moins un catalyseur tel que défini précédemment dans un solvant. La concentration en catalyseur au sein de ladite solution d'imprégnation varie alors de préférence de 0,2 à 50 % molaire et encore plus préférentiellement, de 5 à 15 % molaire.

Le ou les catalyseurs présents dans la composition préparée à l'étape i) ou bien dans la solution d'imprégnation de la couche de matrice de silice amorphe sont de préférence des sels de cations divalents, c'est-à-dire des sels de strontium, de baryum, de calcium, de magnésium et de béryllium choisis parmi les nitrates, les sulfates, les carbonates, les hydroxydes, les chlorures, les acétates, les perchlorates, les oxydes et les alcoxydes ; ou bien des sels de cations monovalents, c'est-à-dire des sels de césium, de rubidium, de sodium, de potassium ou de lithium choisis parmi les nitrates, les sulfates, les carbonates, les hydroxydes, les chlorures, les acétates, les perchlorates, les oxydes et les alcoxydes.

Selon une forme de réalisation préférée de l'invention, les catalyseurs sont des catalyseurs à base de strontium, de calcium ou de baryum et sont choisis parmi les nitrates de strontium tels que Sr(NO₃)₂ les nitrates de calcium tels que Ca(NO₃)₂ et les hydroxydes de baryum tels que Ba(OH)₂.

La nature du solvant de la solution d'imprégnation n'est pas critique à partir du moment où il permet de maintenir en solution le sel du catalyseur utilisé. A titre d'exemple, le solvant de la solution d'imprégnation peut être choisi parmi l'eau et les alcools en C₁-C₄ tels que l'éthanol.

Selon l'invention, on entend par précurseur de silice, un composé susceptible de former de la silice après un traitement thermique à une température supérieure ou égale à 800°C. Il peut être choisi parmi les composés organiques, organométalliques ou minéraux comportant du silicium. Le ou les précurseurs de silice utilisables dans la composition préparée à l'étape i) sont de préférence choisis parmi les alcoxydes de silicium, le tétrachlorure de silicium, les silicates, tels que le silicate d'ammonium, l'acide silicique et leurs mélanges. Parmi les alcoxydes de silicium, on peut en particulier citer le tetraméthoxysilane, le tetraéthoxyorthosilane (TEOS), le (3-mercaptopropyl)-triméthoxysilane, le (3-aminopropyl)triéthoxysilane, le N-(3-triméthoxysilylpropyl)-pyrrole, le 3-(2,4-dinitrophénylamino) propyltriéthoxysilane, le N-(2-aminoéthyl)-3-aminopropyltriméthoxysilane, le phényltriéthoxysilane et le méthyltriéthoxysilane. Parmi ces alcoxydes de silicium, le tetraéthoxyorthosilane est particulièrement préféré.

Typiquement, on désigne par silice colloïdale, des particules amorphes de silice en suspension dans un solvant. Selon l'invention, la silice colloïdale est de préférence choisie parmi les particules de silice dont la taille peut aller jusqu'à 1 µm, varie généralement de 2 à 200 nm, et encore plus préférentiellement entre 7 et 30 nm.

Le ou les précurseurs de silice et/ou la silice colloïdale représentent de préférence de 0,01 à 95 % en masse, et encore plus préférentiellement de 1 à 20 % en masse par rapport à la masse totale de la composition préparée à l'étape i).

Le solvant de la composition préparée à l'étape i) peut par exemple être choisi parmi l'eau, les alcools inférieurs tels que l'éthanol, le méthanol, le propanol et leurs mélanges.

Le dépôt de la composition préparée à l'étape i) sur le substrat peut être effectué sur tout ou partie de la surface du substrat par toute technique appropriée telle que par voie liquide comme le trempage, la vaporisation, l'enduction centrifuge, ou bien par toute autre méthode physique ou chimique connue de l'homme de l'art parmi lesquelles on peut mentionner la pulvérisation cathodique, le dépôt par ablation laser (ou « *Pulsed Laser Déposition* » : PLD, en anglais), le dépôt de couches atomiques (ou « *Atomic Layer Déposition* » : ALD, en anglais), le dépôt chimique en phase vapeur (ou « *Chemical Vapor Déposition* » : CVD, en anglais), l'électrochimie, etc...

Selon l'invention le terme « partie » recouvre toute forme de micro-, nano- et macro-structuration de la couche, telle que séparation de phases, figures de respirations, lithographie, dissolution sélective, anodisation de substrat, démouillage, impression jet d'encre, structuration de surface par agents amphiphiles ou dépôts de billes de latex, impression par tamponnage ou toute autre méthode de structuration de surface directe ou indirecte connue de l'homme du métier, capable de générer des zones de substrat recouvertes de composition et des zones dépourvues de composition.

La composition préparée à l'étape i) peut en outre renfermer un ou plusieurs additifs tels que des agents de contrôle du pH (HCl par exemple), des agents structurants ou modificateurs ou bien encore des agents promoteurs de porosité tels que des polymères, les ammoniums quaternaires et l'urée.

Lors de l'étape ii), la formation de la couche de matrice de silice amorphe peut être obtenue par l'évaporation du solvant de la composition préparée à l'étape i) et provoque la condensation des précurseurs de silice. Cette évaporation peut être réalisée à température ambiante ou bien à une température plus élevée pouvant aller jusqu'à 700°C, de façon à accélérer l'évaporation du solvant et donc la formation de la couche de matrice de silice amorphe. Egalement, lors de l'étape ii), et lorsque la composition préparée à l'étape i) comprend de la silice colloïdale, l'évaporation du solvant entraine l'empilement des colloïdes sous forme d'une couche apte à générer la couche de silice amorphe lors du traitement thermique allant jusqu'à 700°C.

Selon une forme de réalisation préférée de l'invention, l'étape iii) de traitement thermique est réalisée à une température variant de 800 à 1200°C, et encore plus préférentiellement à une température d'environ 1000°C.

La durée de l'étape de traitement thermique peut être choisie en fonction de l'épaisseur de la couche de quartz-α que l'on souhaite obtenir, l'épaisseur étant d'autant plus importante que la durée de l'étape de traitement thermique est longue. Ainsi, et à titre d'exemple, lorsque l'on souhaite obtenir une épaisseur de l'ordre de 150 nm à 700 nm, la durée de l'étape de traitement thermique pourra varier de 2 à 10 heures environ, et lorsque l'on souhaite obtenir des épaisseurs supérieures à 700 nm, alors la durée de l'étape de traitement thermique peut dépasser 24 heures.

L'épaisseur de la couche de quartz dépend également de l'épaisseur de la couche de la composition déposée sur le substrat lors de l'étape i).

Il est également possible de réitérer les étapes i) à iii) une ou plusieurs fois sur un même substrat de façon à former des couches de quartz successives superposées les unes sur les autres ou bien sur des zones différentes d'un même substrat.

Le substrat est de préférence un substrat de silicium cristallin mono-orienté. Dans ce cas, et selon une forme de réalisation particulière de l'invention, le substrat de silicium peut comporter une couche de SiO₂ amorphe native sur laquelle est effectué le dépôt de la composition préparée à l'étape i) afin de favoriser la cristallisation de la matrice de silice amorphe et la formation de quartz-α.

Selon une forme de réalisation particulière et préférée de l'invention, le procédé est un procédé sol-gel, dans lequel :
- la composition utilisée lors de l'étape i) est une composition sol-gel renfermant, dans un solvant, au moins un précurseur de silice,
- la formation de la couche de matrice de silice amorphe à la surface du substrat est réalisée par évaporation du solvant contenu dans la composition sol-gel,
- le substrat est un substrat de silicium cristallin mono-orienté,
- l'étape de traitement thermique de la couche de silice est réalisée en présence d'oxygène et à la pression atmosphérique, et
- le catalyseur est un catalyseur à base de strontium, de baryum ou de calcium au degré d'oxydation (+2) ou capable de générer du strontium, du baryum ou du calcium au degré d'oxydation (+2).

Selon cette forme de réalisation particulière et préférée de l'invention, le catalyseur tout particulièrement préféré est un catalyseur à base de strontium ou de baryum au degré d'oxydation (+2) ou capable de générer du strontium ou du baryum au degré d'oxydation (+2).

Dans ce cas, et lorsque le catalyseur est présent dans la composition sol-gel préparée à l'étape i), alors celle-ci peut en outre renfermer un ou plusieurs agents tensioactifs afin de conférer à la couche de quartz-α finale une nano- ou une microstructuration. En effet, lors de l'évaporation de la composition sol-gel à la surface du substrat de silicium, une séparation de phases se produit entre une phase riche en silice et une seconde phase riche en catalyseur, stabilisée par la présence du tensioactif. Lors du traitement thermique, la phase riche en silice se transforme en quartz-α épitaxié. La poursuite du traitement permet de transférer au substrat de silicium la structure formée par la séparation de phase. Sans vouloir être liés à une quelconque théorie, les inventeurs pensent que le mécanisme à l'origine de cette réplication passe probablement par une oxydation de surface du silicium en SiO₂, puis sa transformation en quartz-α sous les cristaux de quartz déjà formés par le biais de la présence du catalyseur dans les cavités et de la diffusion d'oxygène à travers ces mêmes cavités. Un épaississement de la couche peut donc être envisagé par la consommation progressive du substrat de silicium.

Le ou les tensioactifs utilisables dans ce cas peuvent être choisis parmi les tensioactifs cationiques tels que notamment le bromure de tetradécyltriméthylammonium (TTAB), le bromure de dodécyltriméthylammonium ou le bromure de cétyl-triméthylammonium (CTAB). Le bromure de cétyl-triméthylammonium est particulièrement préféré selon l'invention ;

Le tensioactif peut en outre être un tensioactif anionique choisi parmi le dodécylsulfate de sodium, le dodécylsulfonate de sodium et le dioctylsulfosuccinate de sodium (AOT). Le composé tensioactif peut enfin être un tensioactif non ionique choisi parmi les tensioactifs à tête éthoxylée, et les nonylphénols. Parmi de tels tensioactifs, on peut en particulier citer les copolymères blocs d'éthylèneglycol et de propylèneglycol tels que ceux vendus par exemple sous les dénominations commerciales Pluronic® P123 et Pluronic® F127 par la société BASF.

L'invention a également pour objet le matériau obtenu par la mise en œuvre du procédé tel que défini ci-dessus, ledit matériau étant caractérisé par le fait qu'il comprend un substrat autosupporté choisi parmi le silicium cristallin mono-orienté, le dioxyde de germanium, le corindon, l'oxyde de magnésium, le titanate de strontium, le niobiate de lithium, le tantalate de lithium, l'oxyde de cérium, les oxydes mixtes de gadolinium et de cérium de formule Ce₍₁₋ₓ₎GdₓO₂ dans lesquels x est tel que 0<x<1, l'aluminate de lanthane, le nitrure de gallium, le dioxyde de zirconium dopé à l'yttrium et l'orthophosphate de gallium, ledit support comportant, sur au moins une partie de sa surface, une couche épitaxiée constituée de quartz-α polycristallin mono-orienté comprenant des mésopores et/ou des macropores.

Selon l'invention, la dimension des mésopores peut varier de 2 à 50 nm, en particulier de 15 à 50 nm, et la dimension des macropores peut varier de > 50 nm à 1000 nm, et de préférence de 200 à 500 nm.

L'épaisseur de la couche épitaxiée peut varier de 2 nm jusqu'à 50 µm, préférentiellement jusqu'à 10 µm et très préférentiellement de 5 nm à 5 µm environ.

Du fait des propriétés piézoélectriques intrinsèques du quartz-α et de la possibilité qui est offerte par le procédé de préparation conforme à l'invention qui permet de le préparer en couche mince sur un substrat tel que défini précédemment, et en particulier sur un substrat de silicium, le matériau tel que défini ci-dessus peut être utilisé dans l'industrie dans plusieurs domaines technologiques.

L'invention a donc également pour objet l'utilisation d'un matériau obtenu selon le procédé tel que défini précédemment :
- à titre de composant piézoélectrique, notamment dans un dispositif électronique,
- pour la fabrication d'oscillateurs,
- à titre de filtre spécifique des ondes mécanique et de transducteur des ondes mécaniques en ondes électromagnétiques,
- pour la fabrication de capteurs d'accélération et de vitesse angulaire, ou
- pour la fabrication de capteurs de masse.

Bien entendu, l'homme du métier choisira la nature du substrat en fonction de l'application envisagée, certaines applications nécessitant par exemple d'avoir un substrat conducteur de l'électricité ou bien des propriétés de propagation de phonons différentes de celles de la couche épitaxiée.

D'autre part, le quartz-α est transparent à la lumière visible et aux UV. Le matériau conforme à l'invention et obtenu selon le procédé tel que défini précédemment peut ainsi être utilisé pour la fabrication de lentilles et de guides d'ondes dans le domaine des longueurs d'onde dans le visible ou l'UV.

La résistance chimique très élevée du quartz-α peut être mise à profit. Ainsi le procédé tel que défini précédemment peut être utilisé pour la préparation d'une couche protectrice à la surface du silicium dans des situations où le silicium est très sollicité par les frottements ou l'abrasion ou les environnements chimiques agressifs.

Le matériau conforme à l'invention peut également être utilisé comme isolant électrique. Cette propriété pourrait être utilisée pour la fabrication de différents dispositifs électroniques dans lesquels on a besoin d'une couche isolante comme par exemple dans les jonctions tunnels. L'avantage par rapport à une couche isolante d'une autre nature est la piézoélectricité du matériau qui peut être utilisée dans ce cas comme une variable supplémentaire de contrôle du dispositif, permettant de varier l'épaisseur de la barrière et donc l'intensité des courants tunnels.

Enfin, le matériau conforme à l'invention peut être utilisé comme substrat d'épitaxie. En effet, la cristallinité du quartz peut s'avérer bénéfique à la croissance épitaxiale de certains cristaux d'intérêt biologique.

La présente invention est illustrée par les exemples de réalisation suivants, auxquels elle n'est cependant pas limitée.

### EXEMPLES

Matières premières utilisées dans les exemples :
- Tetraéthoxyorthosilane à 98 % (TEOS) : société Sigma-Aldrich,
- Ethanol (EtOH),
- Acide chlorhydrique (HCl),
- Nitrate de strontium (Sr(NO₃)₂) : société Sigma-Aldrich,
- Hydroxyde de baryum (Ba(OH)₂) société Sigma-Aldrich,
- Bromure de cétyl-triméthylammonium (CTAB) : société Sigma-Aldrich,
- Monohexadécyléther de polyéthylèneglycol vendu sous la dénomination commerciale Brij-56® par la société Sigma-Aldrich.

### EXEMPLE 1

### Préparation d'une couche de quartz α selon le procédé de l'invention

On a préparé une solution de précurseur ayant la composition initiale suivante (en moles) : 1TEOS, 25EtOH, 5H₂O, 0,18HCl, 0,062Sr(NO₃)₂.

Le dépôt de la solution de précurseur a été réalisé sur un substrat de silicium (Si(100)) (dimensions : 0,7 mm d'épaisseur et surface 3 cm x 5 cm) comportant une couche de SiO₂ native de 2,2 mm d'épaisseur par trempage et retrait sous air sec à température ambiante, à une vitesse de 2 mm.s⁻¹.

Après dépôt de la solution de précurseur, le substrat de silicium a été soumis au traitement thermique suivant dans un four tubulaire, sous air et à pression atmosphérique : montée en température de la température ambiante jusqu'à 1000°C à raison de 3°C/min, puis maintien à 1000°C pendant 5 heures.

Le four a ensuite été éteint et on a laissé le substrat refroidir jusqu'à 25°C à raison de 3°C/min.

On a obtenu un support de silicium (100) recouvert d'une couche de quartz α qui a ensuite été caractérisée.

Les mesures d'épaisseur et d'indice de réfraction ont été effectuées par ellipsométrie à l'aide d'un ellipsomètre spectroscopique vendu sous la dénomination commerciale 2000U Woollam par la société VASE ou par microscopie électronique à balayage à émission de champ (MEB ou SEM-FE pour *Scanning Electron Microscopy-Field Emission* en anglais) avec un MEB SU6600 de la société Hitachi.

Les dimensions, la rugosité et l'aspect des cristaux ont été déterminés à l'aide d'un microscope à force atomique (AFM pour « *atomic force microscope* ») vendu par la société Veeco et d'un microscope optique.

L'épitaxie a été déterminée par diffraction de rayons X aux grands angles *via* un diffractomètre vendu sous la dénomination commerciale GADDS D8 en montage Bruker, irradiation Cuivre 1,54056 Å.

La couche de quartz α ainsi obtenue présentait une épaisseur de 180 nm et un indice de réfraction de 1,545, ce qui est très proche de l'indice de réfraction du quartz dense (1,55 à λ= 700 nm).

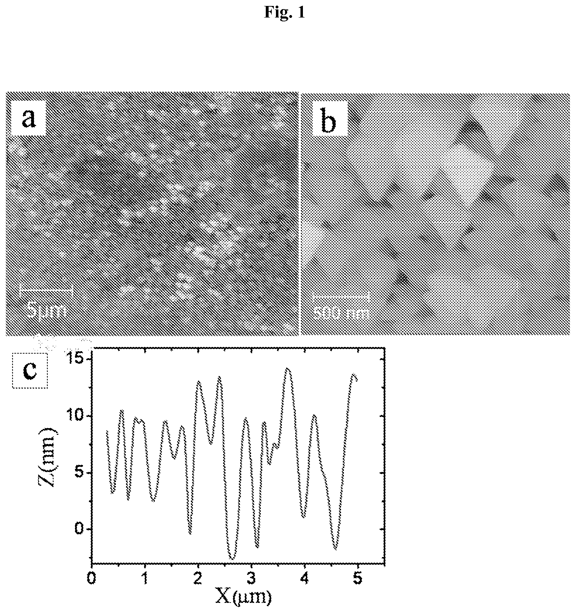

La figure 1 annexée donne les résultats de l'étude topographique de la couche dense de quartz α épitaxiée ainsi obtenue : les figures 1a et 1b sont les images d'AFM de la surface de la couche de quartz α et la figure 1c montre la courbe de l'analyse AFM du profile de la surface de la couche (hauteur Z en nm en fonction de la longueur X en µm).

Il ressort des figures 1a et 1b que les polycristaux de quartz ont une dimension latérale variant de 450 nm à 500 nm.

L'image du profile AFM (fig. 1c) montre que la couche de quartz obtenue présente une très bonne homogénéité : qualité optique parfaite et faible rugosité (RMS = 8 nm).

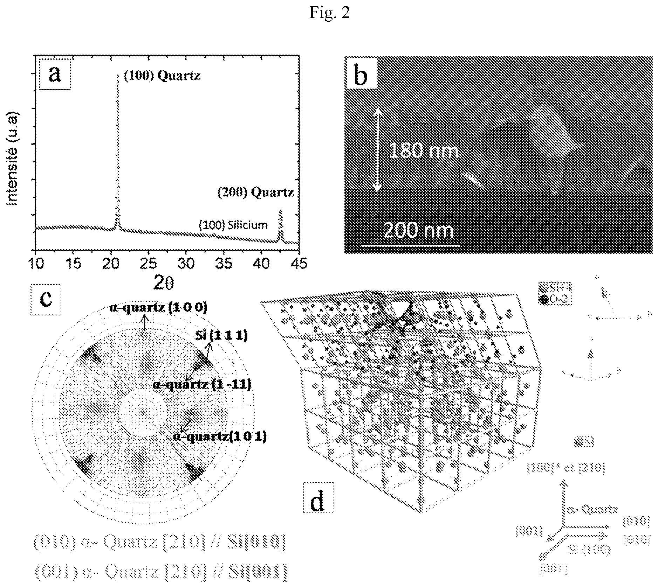

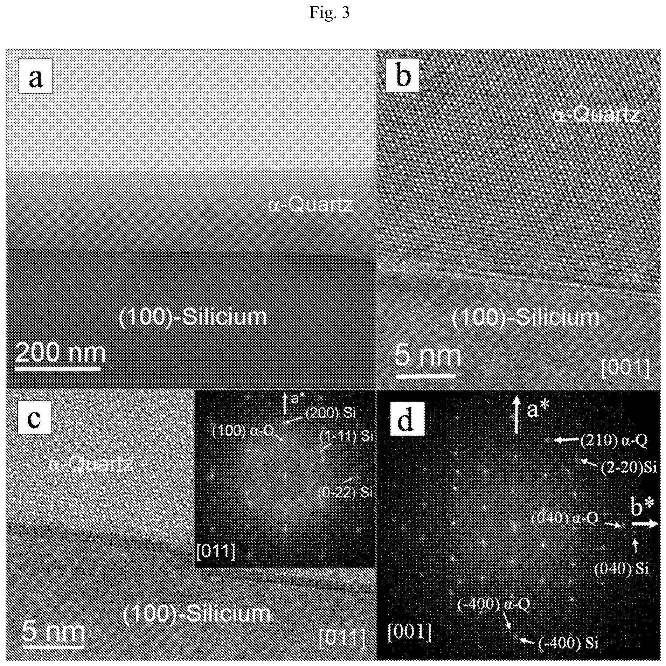

Les résultats de l'étude structurale et microstructurale de la couche de quartz obtenue sont donnés respectivement par les figures 2 et 3 annexées.

La figure 2a montre le spectre XRD (intensité en unités arbitraires en fonction de l'angle 2θ en degrés) ; la figure 2b est l'image de microscopie MEB de la section verticale de la couche de quartz ; la figure 2c est une figure de pole : quartz-α (1 0 0) 2θ = 20,8°, χ : 50°, ϕ : 0° ; Substrat de silicium (1 1 1) χ : 60°, ϕ : 45° 2θ = 28,7° ; α-quartz (1 0 1) χ : 58°, ϕ : 45° 2θ = 26,8° ; α-quartz (1 0 1) χ : 36°, ϕ : 0° , 2θ = 26,8 ; et la figure 2d est un modèle de représentation en 2 dimensions de l'orientation de la couche dense de quartz α épitaxiée.

La figure 3a montre une image de MET a basse magnification de la section transversale en mode (*bright-field*) d'une couche de quartz sur un substrat de silicium orienté selon la direction cristallographique (100). Les figures 3b, c et d, montrent des images a haute résolution de MET de l'interface quartz-silicium à travers les axes de zones cristallographiques [001] et [011] du α quartz respectivement. La figure encadre dans la figure 3c, montre la transformée de Fourier (FFT) de l'image de METHR 3c. La figure 3d montre la FFT de la figure 3b qui confirme la relation d'épitaxie entre le quartz et le silicium.

### EXEMPLE 2

### Préparation d'une couche de quartz-α selon le procédé de l'invention (imprégnation d'une couche mésoporeuse de silice amorphe avec des sels de baryum (Ba²⁺)

Dans cet exemple on montre que l'imprégnation d'une couche mésoporeuse de silice amorphe avec une solution contenant du baryum Ba²⁺ permet de former une couche de quartz-α.

On a préparé une solution de précurseur de silice ayant la composition initiale suivante (en moles) : 1TEOS, 25EtOH, 5H₂O, 0,18HCl, 0,05 Brij-56

Le dépôt de la solution a été réalisé sur un substrat de silicium (Si(100)) (dimensions : 0,7 mm d'épaisseur et surface 3 cm x 5 cm) comportant une couche de SiO₂ native de 2,2 mm d'épaisseur par trempage et retrait sous air sec à température ambiante, à une vitesse de 2 mm.s⁻¹.

Apres dépôt de la solution de précurseur de silice, le substrat de silicium a été soumis au traitement thermique suivant dans un four ouvert sous air et à pression atmosphérique : 5 minutes à 500°C.

On a obtenu un support de silicium (100) recouvert d'une couche de silice amorphe mésoporeuse de 60 mm d'épaisseur et comportant des pores d'environ 3 nm interconnectés dans un réseau 3D.

Suite à la formation de la couche mésoporeuse sol-gel de silice, la porosité a été imprégnée avec une solution 1M d'hydroxyde de baryum Ba(OH)₂ dans l'acide acétique.

L'imprégnation a été réalisée par trempage et retrait sous air sec à température ambiante, à une vitesse de 2 mm.s⁻¹.

Le substrat de silicium a ensuite été soumis au traitement thermique suivant dans un four tubulaire, sous air et à pression atmosphérique : montée en température de la température ambiante jusqu'à 1000°C à raison de 3°C/min, pendant 5heures.

Le four a ensuite été éteint et on a laissé le substrat refroidir jusqu'à 25°C à raison de 3°C/min.

On a obtenu un support de silicium (100) recouvert d'une couche de quartz-α qui a ensuite été caractérisée (épaisseur, indice de réfraction et épitaxie) comme décrit ci-dessus à l'exemple 1.

La couche de quartz α ainsi obtenue présentait une épaisseur de 235 nm et un indice de réfraction de 1,52, ce qui est très proche de l'indice de réfraction du quartz dense (1,55 a λ= 700 nm).

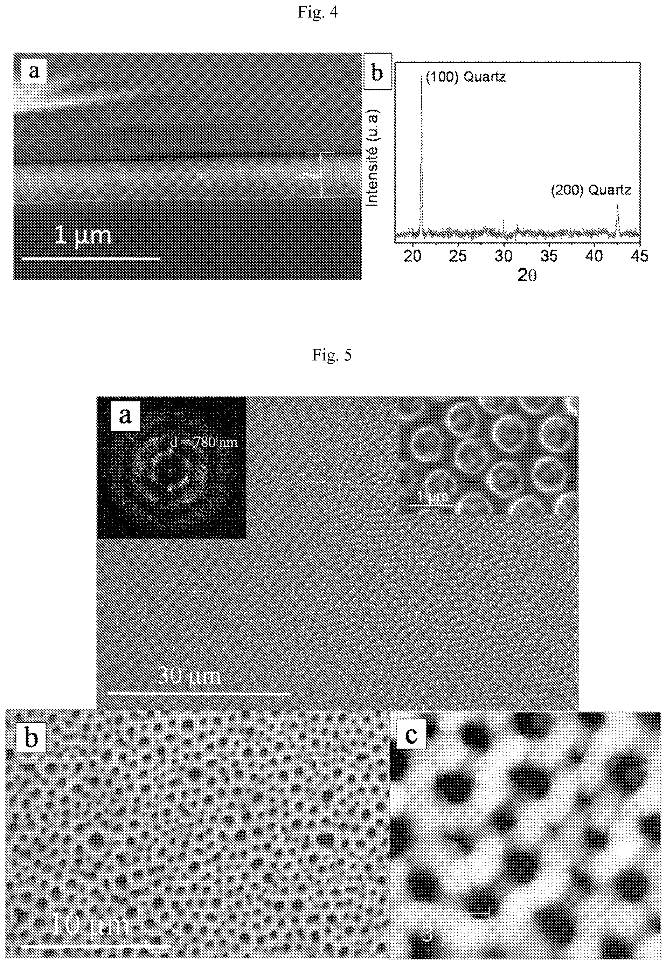

La figure 4 annexée donne les résultats de l'étude de l'épaisseur de la couche dense de quartz-α épitaxiée ainsi obtenue : La figure 4a est l'image de microscopie MEB de la section transversale de la couche de quartz, la figure 4b est l'image du spectre XRD (intensité donnée en unité arbitraire en fonction de l'angle 2θ en degrés).

### EXEMPLE 3

### Préparation d'une couche de quartz-α structurée selon le procédé de l'invention

Dans cet exemple, on montre que la présence d'un tensioactif cationique dans la solution de précurseur permet de micro- ou de nanostructurer la couche de quartz-α épitaxiée. En effet, lors de l'évaporation de la solution de précurseur à la surface du substrat de silicium, une séparation de phases se produit entre une phase riche en silice et une seconde phase riche en strontium, stabilisée par la présence d'un tensioactif tel que le CTAB. Lors du traitement thermique, la phase riche en silice se transforme en quartz épitaxié. Alternativement, un traitement thermique plus long permet de transférer au substrat de Si la structure formée par séparation de phase (formation de pores). Sans vouloir être liés par une quelconque théorie, les Inventeurs supposent que le mécanisme à l'origine de cette réplication passe probablement par une oxydation de surface du Si en SiO₂, puis sa transformation en quartz sous les cristaux de quartz déjà formés par le biais de la présence du catalyseur dans les cavités et de la diffusion d'oxygène à travers ces mêmes cavités. Ce mécanisme reste cependant à vérifier. Un épaississement de la couche est donc envisagé par la consommation progressive du substrat de silicium.

On a préparé une solution de précurseur ayant la composition initiale suivante (en moles): 1TEOS, 25EtOH, 5H₂O, 0,18HCl, 0,114CTAB 0,062Sr(NO₃)₂.

Le dépôt de la couche de quartz a ensuite été réalisé exactement dans les mêmes conditions que celles de l'exemple 1 ci-dessus étant entendu que le traitement thermique a été fait sur une période de 5 heures, ainsi que sur une période de 20 heures.

Les couches de quartz structurées (poreuses) présentent les mêmes caractéristiques (taille des cristaux, orientation, épaisseur) que les couches denses en dehors de la présence des pores. La couche de quartz pure présente des cavités de diamètres homogènes et relativement bien dispersées sur la surface, issue de la séparation de phase.

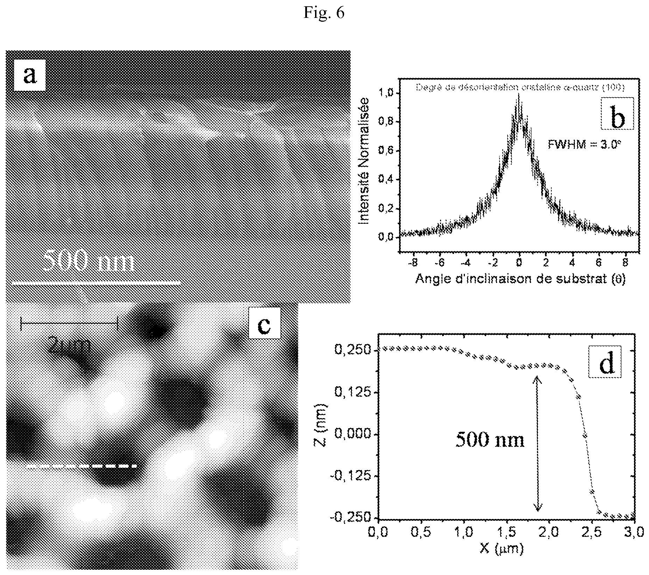

Les figures 5 et 6 montrent les images de la couche de quartz poreuse ainsi obtenue.

La figure 5a est une image prise en MEB et montre l'aspect de la couche avant traitement thermique. On observe la ségrégation de phase qui a donné lieu à une couche nanoporeuse de silice amorphe avec des pores de 780 nm de diamètre et un empilement hexagonal. Les figures 5b et 5c sont des images de microscopie AFM.

La figure 6a est une image de MEB de la section de la couche poreuse de quartz-α épitaxiée ; la figure 6b donne le spectre XRD (intensité en unités arbitraires en fonction de l'angle 2θ en degrés) ; la figure 6c montre l'image en microscopie AFM de la couche poreuse de quartz épitaxiée et la figure 6d donne l'analyse du profil de l'épaisseur de la couche (hauteur Z en nm en fonction de la longueur X en µm).

Les caractéristiques de la couche de quartz-α épitaxiée ainsi obtenue étaient les suivantes :
- Epaisseur de la couche au bout de 5 heures de traitement thermique (ellipsométrie) = 250 nm.
- Epaisseur de la couche au bout de 20 heures de traitement thermique (ellipsométrie) = 500 nm. (cf. image microscopie électronique, Figure 6a et profil du microscope AFM Figure 6d),
- Dimension latérale des cristaux : 40 nm (cf. image microscopie électronique, Figure 5a)
- Dimension latérale des nanopores : 200-500 nm (cf. image microscopie électronique et AFM, Figures 5c).
- Epitaxie : (100) (c.f. Spectre XRD, Figure 6b).

## Revendications

1. Procédé de préparation d'une couche de quartz-α épitaxiée sur support solide, comprenant les étapes suivantes :
i) une étape de préparation d'une composition renfermant, dans un solvant, au moins un précurseur de silice et/ou de la silice colloïdale ;
ii) une étape de dépôt d'une couche de la composition obtenue ci-dessus à l'étape i) sur au moins une partie de la surface d'un substrat et la formation d'une couche de matrice de silice amorphe ;
iii) une étape de traitement thermique de la couche de matrice de silice amorphe obtenue à l'étape ii) pour obtenir une couche de quartz-α épitaxiée,
ledit procédé étant **caractérisé en ce que** :
- le substrat est un substrat autosupporté choisi parmi le silicium cristallin mono-orienté, le dioxyde de germanium, le corindon, l'oxyde de magnésium, le titanate de strontium, le niobiate de lithium, le tantalate de lithium, l'oxyde de cérium, les oxydes mixtes de gadolinium et de cérium de Ce₍₁₋ₓ₎GdₓO₂ dans lesquels x est tel que 0<x<1, l'aluminate de lanthane, le nitrure de gallium, le dioxyde de zirconium dopé à l'yttrium et l'orthophosphate de gallium, et **en ce que** :
- l'étape de traitement thermique de la couche de silice amorphe est réalisée à une température supérieure ou égale à 800°C, en présence d'au moins un catalyseur à base d'un des éléments suivants au degré d'oxydation (+2) : strontium, baryum, calcium, magnésium, béryllium, ou d'un des éléments suivants au degré d'oxydation (+1) : césium, rubidium, lithium, sodium ou potassium, ou capable de générer un des éléments suivants au degré d'oxydation (+2) : strontium, baryum, calcium, magnésium, béryllium, ou un des éléments suivants au degré d'oxydation (+1) : césium, rubidium, sodium, du potassium ou lithium, ledit catalyseur étant présent au sein de ladite matrice de silice amorphe.

2. Procédé selon la revendication 1, **caractérisé en ce que** l'étape de traitement thermique est réalisée en présence d'oxygène.

3. Procédé selon la revendication 1 ou 2, **caractérisé en ce que** le catalyseur est présent dans la composition préparée à l'étape i) et représente de 0,2 à 30 % molaire par rapport au précurseur de silice et/ou à la silice colloïdale.

4. Procédé selon la revendication 1 ou 2, **caractérisé en ce que** le catalyseur est introduit dans la matrice de silice amorphe à la fin de l'étape ii) et avant la réalisation de l'étape iii) de traitement thermique et la couche de matrice de silice amorphe est imprégnée par une solution d'imprégnation contenant au moins ledit catalyseur dans un solvant.

5. Procédé selon la revendication 4, **caractérisé en ce que** la concentration en catalyseur au sein de ladite solution d'imprégnation varie de 0,2 à 50 % molaire.

6. Procédé selon l'une quelconque des revendications précédentes, **caractérisé en ce que** le ou les catalyseurs présents dans la composition préparée à l'étape i) ou bien dans la solution d'imprégnation de la couche de matrice de silice amorphe sont des sels de strontium, de baryum, de calcium, de magnésium ou de béryllium, choisis parmi les nitrates, les sulfates, les carbonates, les hydroxydes, les chlorures, les acétates, les perchlorates, les oxydes et les alcoxydes.

7. Procédé selon l'une quelconque des revendications 1 à 5, **caractérisé en ce que** le ou les catalyseurs présents dans la composition préparée à l'étape i) ou bien dans la solution d'imprégnation de la couche de matrice de silice amorphe sont des sels de césium, de rubidium, de sodium, de potassium ou de lithium choisis parmi les nitrates, les sulfates, les carbonates, les hydroxydes, les chlorures, les acétates, les perchlorates, les oxydes et les alcoxydes.

8. Procédé selon l'une quelconque des revendications précédentes, **caractérisé en ce que** le ou les précurseurs de silice utilisables dans la composition préparée à l'étape i) sont choisis parmi les alcoxydes de silicium, le tétrachlorure de silicium, les silicates, l'acide silicique et leurs mélanges.

9. Procédé selon la revendication 8, **caractérisé en ce que** les alcoxydes de silicium sont choisis parmi le tetraméthoxysilane, le tetraéthoxyorthosilane, le (3-mercaptopropyl)-triméthoxysilane, le (3-aminopropyl)triéthoxysilane, le N-(3-triméthoxysilylpropyl)-pyrrole, le 3-(2,4-dinitrophénylamino)propyltriéthoxysilane, le N-(2-aminoéthyl)-3-aminopropyltriméthoxysilane, le phényltriéthoxysilane et le méthyltriéthoxysilane.

10. Procédé selon l'une quelconque des revendications précédentes, **caractérisé en ce que** le ou les précurseurs de silice et/ou la silice colloïdale représentent de 0,01 à 95 % en masse par rapport à la masse totale de la composition préparée à l'étape i).

11. Procédé selon l'une quelconque des revendications précédentes, **caractérisé en ce que** la composition préparée à l'étape i) renferme en outre un ou plusieurs additifs choisis parmi les agents de contrôle du pH, les agents structurants ou modificateurs ou bien encore les agents promoteurs de porosité.

12. Procédé selon l'une quelconque des revendications précédentes, **caractérisé en ce que** l'étape iii) de traitement thermique est réalisée à une température variant de 800 à 1200°C.

13. Procédé selon l'une quelconque des revendications précédentes, **caractérisé en ce que** les étapes i) à iii) sont réitérées une ou plusieurs fois sur un même substrat de façon à former des couches de quartz successives superposées les unes sur les autres ou bien sur des zones différentes d'un même substrat.

14. Procédé selon l'une quelconque des revendications précédentes, **caractérisé en ce que** le substrat est un substrat de silicium cristallin mono-orienté comportant une couche de SiO₂ amorphe native sur laquelle est effectué le dépôt de la composition préparée à l'étape i).

15. Procédé selon l'une quelconque des revendications précédentes, **caractérisé en ce que** le procédé est un procédé sol-gel dans lequel :
- la composition utilisée lors de l'étape i) est une composition sol-gel renfermant, dans un solvant, au moins un précurseur de silice,
- la formation de la couche de matrice de silice amorphe à la surface du substrat est réalisée par évaporation du solvant contenu dans la composition sol-gel,
- le substrat est un substrat de silicium cristallin mono-orienté,
- l'étape de traitement thermique de la couche de silice est réalisée en présence d'oxygène et à la pression atmosphérique, et
- le catalyseur est un catalyseur à base de strontium, de baryum ou de calcium au degré d'oxydation (+2) ou capable de générer du strontium, du baryum ou du calcium au degré d'oxydation (+2).

16. Procédé selon la revendication 15, **caractérisé en ce que** le catalyseur est un catalyseur à base de strontium ou de baryum au degré d'oxydation (+2) ou capable de générer du strontium ou du baryum au degré d'oxydation (+2).

17. Procédé selon la revendication 15 ou 16, **caractérisé en ce que** le catalyseur est présent dans la composition préparée à l'étape i), et que ladite composition renferme en outre un ou plusieurs agents tensioactifs.

18. Procédé selon la revendication 17, **caractérisé en ce que** le ou les tensioactifs sont choisis parmi les tensioactifs cationiques choisis parmi le bromure de tetradécyltriméthylammonium, le bromure de dodécyltriméthylammonium et le bromure de cétyl-triméthylammonium ; les tensioactifs anioniques choisis parmi le dodécylsulfate de sodium, le dodécylsulfonate de sodium et le dioctylsulfosuccinate de sodium ; et les tensioactifs nonioniques choisis parmi les copolymères blocs d'éthylèneglycol et de propylèneglycol.

19. Matériau obtenu par la mise en œuvre du procédé tel que défini à l'une quelconque des revendications précédentes, **caractérisé en ce qu'**il comprend un substrat autosupporté choisi parmi le silicium cristallin mono-orienté, le dioxyde de germanium, le corindon, l'oxyde de magnésium, le titanate de strontium, le niobiate de lithium, le tantalate de lithium, l'oxyde de cérium, les oxydes mixtes de gadolinium et de cérium de formule Ce₍₁₋ₓ₎GdₓO₂ dans lesquels x est tel que 0<x<1, l'aluminate de lanthane, le nitrure de gallium, le dioxyde de zirconium dopé à l'yttrium et l'orthophosphate de gallium, ledit support comportant, sur au moins une partie de sa surface, une couche épitaxiée constituée de quartz-α polycristallin mono-orienté comprenant des mésopores et/ou des macropores.

20. Matériau selon la revendication 19, **caractérisé en ce que** l'épaisseur de la couche épitaxiée varie de 2 nm à 50 µm.

21. Utilisation d'un matériau tel que défini à l'une quelconque des revendications 19 ou 20 à titre de composant piézoélectrique.

22. Utilisation d'un matériau tel que défini à l'une quelconque des revendications 19 ou 20 pour la fabrication d'oscillateurs.

23. Utilisation d'un matériau tel que défini à l'une quelconque des revendications 19 ou 20 à titre de filtre spécifique des ondes mécanique et de transducteur des ondes mécaniques en ondes électromagnétiques.

24. Utilisation d'un matériau tel que défini à l'une quelconque des revendications 19 ou 20, pour la fabrication de capteurs d'accélération et de vitesse angulaire ou pour la fabrication de capteurs de masse.

25. Utilisation d'un matériau tel que défini à l'une quelconque des revendications 19 ou 20, pour la fabrication de lentilles et de guides d'ondes dans le domaine des longueurs d'onde dans le visible ou l'UV.

26. Utilisation d'un matériau tel que défini à l'une quelconque des revendications 19 ou 20, comme isolant électrique.

27. Utilisation d'un matériau tel que défini à l'une quelconque des revendications 19 ou 20, comme substrat d'épitaxie.

## Patentansprüche

1. Verfahren der Herstellung einer Schicht von epitaxiertem α-Quarz auf festem Untergrund, welches die folgenden Schritte aufweist:
i) einen Schritt der Herstellung einer Zusammensetzung, welche, in einem Lösemittel, mindestens einen Präkursor von Siliciumdioxid und/oder kolloidalem Siliciumdioxid umfasst,
ii) einen Schritt des Deponierens einer Schicht der Zusammensetzung, welche obenstehend im Schritt i) erhalten wurde, auf mindestens einem Teil der Oberfläche eines Substrats und der Bildung einer Schicht an amorpher Silicamatrix,
iii) einen Schritt der thermischen Behandlung der Schicht an amorpher Silicamatrix, welche in Schritt ii) erhalten wurde, zum Erhalten einer Schicht von epitaxiertem α-Quarz,
wobei besagtes Verfahren **dadurch gekennzeichnet ist, dass**:
- das Substrat ein selbsttragendes Substrat ist, ausgewählt aus mono-orientiertem, kristallinem Silicium, Germaniumdioxid, Korund, Magnesiumoxid, Strontiumtitanat, Lithiumniobat, Lithiumtantalat, Ceroxid, Mischoxiden von Gadolinium und Cer aus Ce₍₁₋ₓ₎GdₓO₂, in denen x derart ist, dass 0<x<1, Lanthanaluminat, Galliumnitrid, mit Yttrium-dotiertem Zirkoniumdioxid und Galliumorthophosphat, und dadurch, dass
- der Schritt der thermischen Behandlung der amorphen Silicaschicht realisiert wird bei einer Temperatur höher oder gleich 800 °C, in Präsenz von wenigstens einem Katalysator basierend auf einem der folgenden Elemente mit Oxidationsstufe (+2): Strontium, Barium, Calcium, Magnesium, Beryllium, oder einem der folgenden Elemente mit Oxidationsstufe (+1): Cäsium, Rubidium, Lithium, Natrium oder Kalium, oder fähig eines der folgenden Elemente mit Oxidationsstufe (+2) zu generieren: Strontium, Barium, Calcium, Magnesium, Beryllium, oder eines der folgenden Elemente mit Oxidationsstufe (+1) zu generieren: Cäsium, Rubidium, Natrium, von Kalium oder Lithium, wobei besagter Katalysator präsent ist im Inneren der besagten amorphen Silicamatrix.

2. Verfahren gemäß Anspruch 1, **dadurch gekennzeichnet ist, dass** der Schritt der thermischen Behandlung realisiert wird in Präsenz von Sauerstoff.

3. Verfahren gemäß Anspruch 1 oder 2, **dadurch gekennzeichnet, dass** der Katalysator präsent ist in der in Schritt i) hergestellten Zusammensetzung und 0,2 bis 30 Mol-% bezogen auf den Präkursor von Siliciumdioxid und/oder kolloidalem Siliciumdioxid ausmacht.

4. Verfahren gemäß Anspruch 1 oder 2, **dadurch gekennzeichnet, dass** der Katalysator eingeführt wird in die amorphe Silicamatrix am Ende des Schritts ii) und vor der Ausführung des Schritts iii) der thermischen Behandlung, und die Schicht der amorphen Silicamatrix imprägniert wird mittels einer Imprägnierlösung, welche mindestens besagten Katalysator in einem Lösemittel enthält.

5. Verfahren gemäß Anspruch 4, **dadurch gekennzeichnet, dass** die Konzentration an Katalysator im Inneren der besagten Imprägnierlösung von 0,2 bis 50 Mol-% variiert.

6. Verfahren gemäß irgendeinem der vorangegangenen Ansprüche, **dadurch gekennzeichnet, dass** der oder die Katalysatoren, welche präsent sind in der in Schritt i) hergestellten Zusammensetzung oder in der Imprägnierlösung der Schicht der amorphen Silicamatrix, Salze sind aus Strontium, Barium, Calcium, Magnesium oder Beryllium, ausgewählt aus Nitraten, Sulfaten, Carbonaten, Hydroxiden, Chloriden, Acetaten, Perchloraten, Oxiden und Alkoxiden.

7. Verfahren gemäß irgendeinem der Ansprüche 1 bis 5, **dadurch gekennzeichnet, dass** der oder die Katalysatoren, welche präsent sind in der in Schritt i) hergestellten Zusammensetzung oder in der Imprägnierlösung der Schicht der amorphen Silicamatrix, Salze sind aus Cäsium, Rubidium, Natrium, Kalium oder Lithium, ausgewählt aus Nitraten, Sulfaten, Carbonaten, Hydroxiden, Chloriden, Acetaten, Perchloraten, Oxiden und Alkoxiden.

8. Verfahren gemäß irgendeinem der vorangegangenen Ansprüche, **dadurch gekennzeichnet, dass** der oder die Präkursoren von Siliciumdioxid, welche verwendbar sind in der in Schritt i) hergestellten Zusammensetzung, ausgewählt sind aus Siliciumalkoxiden, Siliciumtetrachlorid, Silikaten, Kieselsäure und Mischungen von diesen.

9. Verfahren gemäß Anspruch 8, **dadurch gekennzeichnet, dass** die Siliciumalkoxide ausgewählt sind aus Tetramethoxysilan, Tetraethoxyorthosilan, (3-Mercaptopropyl)-trimethoxysilan, (3-Aminopropyl)triethoxysilan, N-(3-Trimethoxysilylpropyl)-pyrrol, 3-(2,4-Dinitrophenylamino)propyltriethoxysilan, N-(2-Aminoethyl)-3-aminopropyltrimethoxysilan, Phenyltriethoxysilan und Methyltriethoxysilan.

10. Verfahren gemäß irgendeinem der vorangegangenen Ansprüche, **dadurch gekennzeichnet, dass** der oder die Präkursoren von Siliciumdioxid und/oder kolloidalem Siliciumdioxid 0,01 bis 95 Masse-% bezogen auf die Gesamtmasse der in Schritt i) hergestellten Zusammensetzung ausmachen.

11. Verfahren gemäß irgendeinem der vorangegangenen Ansprüche, **dadurch gekennzeichnet, dass** die in Schritt i) hergestellte Zusammensetzung weiterhin einen oder mehrere Zusatzstoffe ausgewählt aus pH-Kontrollmitteln, Strukturmitteln oder Modifikatormitteln oder auch Porositätsvermittlern aufweist.

12. Verfahren gemäß irgendeinem der vorangegangenen Ansprüche, **dadurch gekennzeichnet, dass** der Schritt iii) der thermischen Behandlung realisiert wird bei einer Temperatur, welche von 800 bis 1200 °C variiert.

13. Verfahren gemäß irgendeinem der vorangegangenen Ansprüche, **dadurch gekennzeichnet, dass** die Schritte i) bis iii) ein oder mehrere Male auf einem selben Substrat wiederholt werden, um sukzessive, übereinander oder über verschiedenen Zonen eines selben Substrats überlagerte Quartzschichten zu bilden.

14. Verfahren gemäß irgendeinem der vorangegangenen Ansprüche, **dadurch gekennzeichnet, dass** das Substrat ein Substrat von mono-orientiertem, kristallinem Silicium ist, welches eine Schicht von nativem, amorphem SiO₂ aufweist, auf der das Deponieren der in Schritt i) hergestellten Zusammensetzung durchgeführt wird.

15. Verfahren gemäß irgendeinem der vorangegangenen Ansprüche, **dadurch gekennzeichnet, dass** das Verfahren ein Sol-Gel-Verfahren ist, worin:
- die bei Schritt i) verwendete Zusammensetzung eine Sol-Gel-Zusammensetzung ist, welche, in einem Lösemittel, wenigstens einen Präkursor von Siliciumdioxid aufweist,
- die Bildung der Schicht der amorphen Silicamatrix auf der Oberfläche des Substrats realisiert wird mittels Evaporation des Lösemittels, welches in der Sol-Gel-Zusammensetzung enthalten ist,
- das Substrat ein mono-orientiertes, kristallines Siliciumsubstrat ist,
- der Schritt der thermischen Behandlung der Silicaschicht realisiert wird in Präsenz von Sauerstoff und unter atmosphärischem Druck, und
- der Katalysator ein Katalysator basierend auf Strontium, Barium oder Calcium mit Oxidationsstufe (+2) ist oder fähig ist, Strontium, Barium oder Calcium mit Oxidationsstufe (+2) zu generieren.

16. Verfahren gemäß Anspruch 15, **dadurch gekennzeichnet, dass** der Katalysator ein Katalysator basierend auf Strontium oder Barium mit Oxidationsstufe (+2) ist oder fähig ist, Strontium oder Barium mit Oxidationsstufe (+2) zu generieren.

17. Verfahren gemäß Anspruch 15 oder 16, **dadurch gekennzeichnet, dass** der Katalysator präsent ist in der in Schritt i) hergestellten Zusammensetzung und dass die besagte Zusammensetzung weiterhin eines oder mehrere Tenside aufweist.

18. Verfahren gemäß Anspruch 17, **dadurch gekennzeichnet, dass** das oder die Tenside ausgewählt sind aus kationischen Tensiden, ausgewählt aus Tetradecyltrimethylammoniumbromid, Dodecyltrimethylammoniumbromid und Cetyltrimethylammoniumbromid, anionischen Tensiden, ausgewählt aus Natriumdodecylsulfat, Natriumdodecylsulfonat und Natriumdioctylsulfosuccinat, und nicht-ionischen Tensiden, ausgewählt aus Copolymer-Blöcken von Ethylenglycol und Propylenglycol.

19. Material, welches erhalten ist durch Durchführen des Verfahrens gemäß irgendeinem der vorangegangenen Ansprüche, **dadurch gekennzeichnet, dass** es ein selbsttragendes Substrat aufweist, ausgewählt aus mono-orientiertem, kristallinem Silicium, Germaniumdioxid, Korund, Magnesiumoxid, Strontiumtitanat, Lithiumniobat, Lithiumtantalat, Ceroxid, Mischoxiden aus Gadolinium und Cer der Formel Ce₍₁₋ₓ₎GdₓO₂, wobei x derart ist, dass 0<x<1, Lanthanaluminat, Galliumnitrid, Yttrium-dotiertem Zirkoniumdioxid und Galliumorthophosphat, wobei besagte Unterlage, auf wenigstens einem Teil der Oberfläche, eine epitaxierte Schicht aufweist, welche aus mono-orientiertem, polykristallinem α-Quarz gebildet ist, welches Mesoporen und/oder Makroporen aufweist.

20. Material gemäß Anspruch 19, **dadurch gekennzeichnet, dass** die Stärke der epitaxierten Schicht von 2 nm bis 50 µm variiert.

21. Verwendung eines Materials gemäß einem der Ansprüche 19 oder 20 als piezoelektrische Komponente.

22. Verwendung eines Materials gemäß einem der Ansprüche 19 oder 20 zur Herstellung von Oszillatoren.

23. Verwendung eines Materials gemäß einem der Ansprüche 19 oder 20 als spezifischer Filter von mechanischen Wellen und als Transduktor von mechanischen Wellen in elektromagnetischen Wellen.

24. Verwendung eines Materials gemäß einem der Ansprüche 19 oder 20 zur Herstellung von Winkelbeschleunigungs- und Winkelgeschwindigkeitssensoren oder zur Herstellung von Massensensoren.

25. Verwendung eines Materials gemäß einem der Ansprüche 19 oder 20 zur Herstellung von Linsen und Wellenleitern im Bereich der Wellenlängen im Sichtbaren und im UV.

26. Verwendung eines Materials gemäß einem der Ansprüche 19 oder 20 als elektrischer Isolator.

27. Verwendung eines Materials gemäß einem der Ansprüche 19 oder 20 als Epitaxiesubstrat.

## Claims

1. Process for preparing an epitaxial α-quartz layer on a solid support, comprising the following steps:
i) a step of preparing a composition containing, in a solvent, at least one silica and/or colloidal silica precursor;
ii) a step of depositing a layer of the composition obtained above in step i) onto at least part of the surface of a substrate and the formation of an amorphous silica matrix layer;
iii) a step of heat treatment of the amorphous silica matrix layer obtained in step ii) to obtain an epitaxial α-quartz layer,
said process being **characterized in that**:
- the substrate is a self-supporting substrate chosen from mono-oriented crystalline silicon, germanium dioxide, corundum, magnesium oxide, strontium titanate, lithium niobiate, lithium tantalate, cerium oxide, gadolinium cerium mixed oxides Ce₍₁₋ₓ₎GdₓO₂ in which x is such that 0 < x < 1, lanthanum aluminate, gallium nitride, yttrium-doped zirconium dioxide and gallium orthophosphate, and **in that**
- the step of heat treatment of the amorphous silica layer is performed at a temperature of greater than or equal to 800°C, in the presence of at least one catalyst based on one of the following elements in oxidation state (+2): strontium, barium, calcium, magnesium, beryllium, or one of the following elements in oxidation state (+1): caesium, rubidium, lithium, sodium or potassium, or capable of generating one of the following elements in oxidation state (+2): strontium, barium, calcium, magnesium, beryllium, or one of the following elements in oxidation state (+1): caesium, rubidium, sodium, potassium or lithium, said catalyst being present in said amorphous silica matrix.

2. Process according to Claim 1, **characterized in that** the heat treatment step is performed in the presence of oxygen.

3. Process according to Claim 1 or 2, **characterized in that** the catalyst is present in the composition prepared in step i) and represents from 0.2 mol% to 30 mol% relative to the silica precursor and/or the colloidal silica precursor.

4. Process according to Claim 1 or 2, **characterized in that** the catalyst is introduced into the amorphous silica matrix at the end of step ii) and before performing the heat treatment step iii) and the amorphous silica matrix layer is impregnated with an impregnation solution containing at least said catalyst in a solvent.

5. Process according to Claim 4, **characterized in that** the concentration of catalyst in said impregnation solution ranges from 0.2 mol% to 50 mol%.

6. Process according to any one of the preceding claims, **characterized in that** the catalyst(s) present in the composition prepared in step i) or in the impregnation solution for the amorphous silica matrix layer are strontium, barium, calcium, magnesium or beryllium salts, chosen from the nitrates, sulfates, carbonates, hydroxides, chlorides, acetates, perchlorates, oxides and alkoxides.

7. Process according to any one of Claims 1 to 5, **characterized in that** the catalyst(s) present in the composition prepared in step i) or in the impregnation solution for the amorphous silica matrix layer are caesium, rubidium, sodium, potassium or lithium salts chosen from the nitrates, sulfates, carbonates, hydroxides, chlorides, acetates, perchlorates, oxides and alkoxides.

8. Process according to any one of the preceding claims, **characterized in that** the silica precursor(s) that may be used in the composition prepared in step i) are chosen from silicon alkoxides, silicon tetrachloride, silicates and silicic acid, and mixtures thereof.

9. Process according to Claim 8, **characterized in that** the silicon alkoxides are chosen from tetramethoxysilane, tetraethoxyorthosilane, (3-mercaptopropyl)trimethoxysilane, (3-aminopropyl)triethoxysilane, N-(3-trimethoxysilylpropyl)pyrrole, 3-(2,4-dinitrophenylamino)propyltriethoxysilane, N-(2-aminoethyl)-3-aminopropyltrimethoxysilane, phenyltriethoxysilane and methyltriethoxysilane.

10. Process according to any one of the preceding claims, **characterized in that** the silica and/or colloidal silica precursor(s) represent from 0.01% to 95% by mass relative to the total mass of the composition prepared in step i).

11. Process according to any one of the preceding claims, **characterized in that** the composition prepared in step i) also contains one or more additives chosen from pH regulators, structuring or modifying agents, and porosity promoters.

12. Process according to any one of the preceding claims, **characterized in that** the heat treatment step iii) is performed at a temperature ranging from 800 to 1200°C.

13. Process according to any one of the preceding claims, **characterized in that** steps i) to iii) are repeated one or more times on the same substrate so as to form successive quartz layers superposed one on the other, or else on different zones of the same substrate.

14. Process according to any one of the preceding claims, **characterized in that** the substrate is a mono-oriented crystalline silicon substrate comprising a layer of native amorphous SiO₂ onto which is deposited the composition prepared in step i).

15. Process according to any one of the preceding claims, **characterized in that** the process is a sol-gel process in which:
- the composition used in step i) is a sol-gel composition containing, in a solvent, at least one silica precursor,
- the formation of the amorphous silica matrix layer on the surface of the substrate is performed by evaporating the solvent contained in the sol-gel composition,
- the substrate is a mono-oriented crystalline silicon substrate,
- the step of heat treatment of the silica layer is performed in the presence of oxygen and at atmospheric pressure, and
- the catalyst is a catalyst based on strontium, barium or calcium in oxidation state (+2) or which is capable of generating strontium, barium or calcium in oxidation state (+2).

16. Process according to Claim 15, **characterized in that** the catalyst is a catalyst based on strontium or barium in oxidation state (+2) or capable of generating strontium or barium in oxidation state (+2).

17. Process according to Claim 15 or 16, **characterized in that** the catalyst is present in the composition prepared in step i), and said composition also contains one or more surfactants.

18. Process according to Claim 17, **characterized in that** the surfactant(s) are chosen from cationic surfactants chosen from tetradecyltrimethylammonium bromide, dodecyltrimethylammonium bromide and cetyltrimethylammonium bromide; anionic surfactants chosen from sodium dodecyl sulfate, sodium dodecylsulfonate and sodium dioctylsulfosuccinate; and nonionic surfactants chosen from block copolymers of ethylene glycol and of propylene glycol.

19. Material obtained by performing the process as defined in any one of the preceding claims, **characterized in that** it comprises a self-supporting substrate chosen from mono-oriented crystalline silicon, germanium dioxide, corundum, magnesium oxide, strontium titanate, lithium niobiate, lithium tantalate, cerium oxide, gadolinium cerium mixed oxides of formula Ce₍₁₋ₓ₎GdₓO₂ in which x is such that 0 < x < 1, lanthanum aluminate, gallium nitride, yttrium-doped zirconium dioxide and gallium orthophosphate, said support comprising, on at least part of its surface, an epitaxial layer consisting of mono-oriented polycrystalline α-quartz comprising mesopores and/or macropores.

20. Material according to Claim 19, **characterized in that** the thickness of the epitaxial layer ranges from 2 nm to 50 µm.

21. Use of a material as defined in either of Claims 19 and 20, as a piezoelectric component.

22. Use of a material as defined in either of Claims 19 and 20, for the manufacture of oscillators.

23. Use of a material as defined in either of Claims 19 and 20, as a specific filter for mechanical waves and for transducing mechanical waves into electromagnetic waves.

24. Use of a material as defined in either of Claims 19 and 20, for the manufacture of accelerometers and angular velocity pickups or for the manufacture of mass sensors.

25. Use of a material as defined in either of Claims 19 and 20, for the manufacture of lenses and waveguides in the visible or UV wavelength range.

26. Use of a material as defined in either of Claims 19 and 20, as an electrical insulator.

27. Use of a material as defined in either of Claims 19 and 20, as an epitaxy substrate.
